# EUROPÄISCHE PATENTSCHRIFT

(11) **EP 3 557 962 B1**
(45) Veröffentlichungstag und Bekanntmachung des Hinweises auf die Patenterteilung: **28.04.2021**
(21) Anmeldenummer: 19000142.0
(22) Anmeldetag: 22.03.2019
(51) Int. Cl.: H05K 7/14, H02B 1/36, A47B 88/00

(54) **HALTEVORRICHTUNG ZUR EINSCHIEB- UND AUSZIEHBAREN LAGERUNG EINES UMFORMERS IN EINEM SCHALTSCHRANK**
HOLDING DEVICE FOR INSERTABLE AND RETRACTABLE STORAGE OF A POWER CONVERTER IN A SWITCH CABINET
DISPOSITIF DE RETENUE DESTINÉ AU LOGEMENT GLISSANT ET EXTRACTIBLE D'UN TRANSDUCTEUR DANS UNE ARMOIRE DE COMMANDE

(30) Priorität: 18.04.2018 DE 102018003189
(43) Veröffentlichungstag der Anmeldung: 23.10.2019
(73) Patentinhaber: Andersen, Peter, 21075 Hamburg (DE)
(72) Erfinder: Andersen, Peter, 21075 Hamburg (DE); Schönfeldt, Kevin, 22397 Hamburg (DE)
(74) Vertreter: Lelgemann, Karl-Heinz

(56) Entgegenhaltungen:
- EP-A1- 2 538 542
- US-A- 6 076 906
- US-A1- 2010 123 377

## Beschreibung

Die Erfindung bezieht sich auf einen Schaltschrank mit einer Haltevorrichtung zur einschieb- und ausziehbaren Lagerung eines Umformers in dem Schaltschrank. Bekannte derartige Haltevorrichtungen haben eine Tragkonstruktion, die unterhalb des Umformers angeordnet ist. Zu der Tragkonstruktion gehören Schwerlastschienen, die an zwei einander gegenüberliegenden Unterkanten des Umformers angeordnet sind und die dort in geeigneter Weise mit dem Schaltschrank verbunden sind. Entsprechend kann die Tragkonstruktion und mit ihr der auf ihr befindliche Umformer aus dem Schaltschrank herausgezogen und in den Schaltschrank hineingeschoben werden.

Aufgrund der insgesamt unterhalb des Umformers angeordneten Haltevorrichtung ergeben sich Probleme hinsichtlich der maßgeblichen elektrischen Anschlüsse des Umformers, die üblicherweise am unteren Ende desselben angeordnet sind. Diese sind aufgrund der unterhalb des Umformers angeordneten Tragkonstruktion bzw. Haltevorrichtung nur schwer zugänglich. Darüber hinaus ist eine mit Nachteilen einhergehende Umlenkung einer Kühlwasseranlage des Umformers erforderlich. Insgesamt ist der im Schaltschrank vorhandene Bauraum unterhalb des Umformers nicht nutzbar. Die Wartung an den dort vorgesehenen elektrischen Anschlüssen des Umformers ist erheblich erschwert. Die Haltevorrichtung bzw. Tragkonstruktion des Umformers sowie die darin integrierte Ausschubmechanik erfordert erheblichen Bauraum, der für andere im Schaltschrank unterzubringende Aggregate nicht zur Verfügung steht. Ein Austausch des Umformers ist vergleichsweise aufwendig. Das Dokument US 6 076 906 A offenbart einen Schaltschrank mit einer ausziehbaren Haltevorrichtung für elektronische Baugruppen, wobei die Haltevorrichtung eine vertikale Wand aufweist, an der ausziehbare Schienen befestigt sind. Das Dokument EP 2 538 542 A1 zeigt einen in einem Gehäuse montierten Umrichter.

Der Erfindung liegt die Aufgabe zugrunde, eine Haltevorrichtung zur einschieb- und ausziehbaren Lagerung eines Umformers in einem Schaltschrank zur Verfügung zu stellen, die die vorstehend erwähnten Nachteile nicht hat und die darüber hinaus mit einem vergleichsweise geringen technisch-konstruktiven Aufwand realisierbar ist, wobei insbesondere der für die Haltevorrichtung erforderliche Bauraum innerhalb des Schaltschranks minimiert werden soll.

Diese Aufgabe wird erfindungsgemäß durch den Gegenstand des Anspruchs 1 gelöst. Hierbei weist ein Schaltschrank eine Aufnahmeplatte auf, die parallel zu einer vertikalen Seitenwand des Schaltschranks angeordnet und an der einseitig der Umformer angebracht ist, zwei ausziehbaren Schwerlastschienen, von denen die eine mit einem oberen Endabschnitt und die andere mit einem unteren Endabschnitt der Aufnahmeplatte auf der dem Umformer abgewandten Seite derselben verbunden ist, und zwei Tragbleche, an denen jeweils eine der beiden ausziehbaren Schwerlastschienen gehaltert ist und die an einer Rahmenkonstruktion des Schaltschranks montiert sind. Aufgrund der seitlichen bzw. vertikalen Anordnung der Aufnahmeplatte wird unterhalb des Umformers kein Bauraum für die Ausgestaltung der Haltevorrichtung benötigt. Die Zugänglichkeit unterhalb des Umformers vorgesehener elektrischer Anschlüsse ist somit aufgrund der Haltevorrichtung nicht beeinträchtigt. Eine Umlenkung der Kühlwasseranlage wird nicht erforderlich. Der Bauraum unterhalb des an der seitlich angeordneten Aufnahmeplatte vorgesehenen Umformers ist in wesentlichen Teilen für andere Zwecke nutzbar. Eine Wartung der elektrischen Anschlüsse des Umformers ist in einfacher Weise möglich.

Gemäß einer vorteilhaften Weiterbildung hat die Haltevorrichtung ein weiteres Tragblech, das unterhalb des der am unteren Endabschnitt der Aufnahmeplatte angebrachten Schwerlastschiene zugeordneten Tragblechs angeordnet ist, wobei an einem am oberen Endabschnitt der Aufnahmeplatte angeordneten Träger und am am unteren Endabschnitt der Aufnahmeplatte unterhalb des ersten unteren Tragblechs angeordneten weiteren Tragblech jeweils ein Fixierblech angeordnet ist, an denen die den Umformer halternde Aufnahmeplatte im Normalbetrieb des Umrichters mittels Verschraubungen fixierbar ist. Mittels der Verschraubungen ist für den Normalbetrieb eine Fixierung und Blockierung der Haltevorrichtung innerhalb des Schaltschranks bzw. an der Rahmenkonstruktion des Schaltschranks realisierbar. Die Fixierbleche nehmen einen Großteil der vertikalen und auch der horizontalen Kräfte von den ausziehbaren Schwerlastschienen. Durch Lösen der Verschraubungen, mittels denen die Aufnahmeplatte an den Fixierblechen fixiert ist, wird die Haltevorrichtung in einen Betriebszustand versetzt, in der sie und der auf ihr gehalterte Umformer in den Schaltschrank einschiebbar bzw. aus dem Schaltschrank ausziehbar ist.

Zweckmäßigerweise ist die Haltevorrichtung mit einem Winkelstahlglied versehen, das so an der Aufnahmeplatte befestigt ist, dass es in der vollständig in den Schaltschrank eingeschobenen und in der vollständig aus dem Schaltschrank ausgezogenen Grenzstellung der Aufnahmeplatte bzw. des Umformers an Innenkanten der Rahmenkonstruktionen des Schaltschranks anschlägt, wobei es die Bewegung der Aufnahmeplatte bzw. des Umformers in Auszugrichtung blockiert, kurz bevor eine Endlagensicherung der Schwerlastschiene erreicht ist. Hierdurch wird verhindert, dass beim Ausziehen und Einschieben der Haltevorrichtung bzw. des Umformers in den Schaltschrank mechanische Beschädigungen auftreten können.

Gemäß einer vorteilhaften Ausführungsform der erfindungsgemäßen Haltevorrichtung ist der das am am oberen Endabschnitt der Aufnahmeplatte angeordneten Tragblech angeordnete Fixierblech halternde Träger in die Rahmenkonstruktion des Schaltschranks integriert. Hierdurch kann eine vorteilhafte Ableitung mechanischer Beanspruchungen im Normalbetrieb des Umformers realisiert werden.

Entsprechend ist es vorteilhaft, wenn das an der aus den beiden am unteren Endabschnitt der Aufnahmeplatte angeordneten Tragblechen gebildeten Tragblechanordnung angeordnete Fixierblech am weiteren Tragblech dieser Tragblechanordnung befestigt ist.

Wenn es das Anforderungsprofil an die Aufnahmeplatte erfordert, ist es zweckmäßig, dass die Aufnahmeplatte an ihrer dem Umformer abgewandten Seite mittels daran angebrachter, vorzugsweise angeschweißter Versteifungsstreben verstärkt ist.

So können auch hohe mechanische Beanspruchungen der Aufnahmeplatte bewerkstelligt werden.

Gemäß einer weiteren vorteilhaften Weiterbildung weist die Haltevorrichtung ein weiteres Winkelstahlglied auf, wobei das erste Winkelstahlglied und das weitere Winkelstahlglied verstellbar an einem Sockelblech anschraubbar sind, das an der dem Umformer abgewandten Seite der Aufnahmeplatte angebracht, vorzugsweise angeschweißt ist. Durch das Vorsehen zweier derartiger verstellbarer Winkelstahlglieder kann realisiert werden, dass die gesamte in Verbindung mit dem Umformer und der Aufnahmeplatte vorgesehene Ausziehmechanik beim Ausfahrvorgang nicht mehr vollständig ausgefahren wird, sondern durch das dem Ausziehvorgang zugeordnete weitere Winkelstahlglied je nach Bedarf frühzeitig stoppbar ist.

Im Folgenden wird die Erfindung anhand einer Ausführungsform unter Bezugnahme auf die Zeichnung näher erläutert.

Es zeigen:
Figur 1 eine perspektivische Darstellung eines mit einer Ausführungsform einer erfindungsgemäßen Haltevorrichtung zur einschieb- und ausziehbaren Halterung eines Umformers ausgerüsteten Schaltschranks;
Figur 2 den in Figur 1 gezeigten Schaltschrank in geöffneter Stellung mit ausgezogener Haltevorrichtung;
Figur 3 eine perspektivische Explosionsdarstellung der in den Figuren 1 und 2 gezeigten Ausführungsform der erfindungsgemäßen Haltevorrichtung;
Figur 4 eine perspektivische Darstellung der in Figur 3 gezeigten erfindungsgemäßen Haltevorrichtung im montierten Zustand; und
Figur 5 eine vergrößerte Darstellung des Bereichs des oberen Endabschnitts einer Aufnahmeplatte der erfindungsgemäßen Haltevorrichtung.

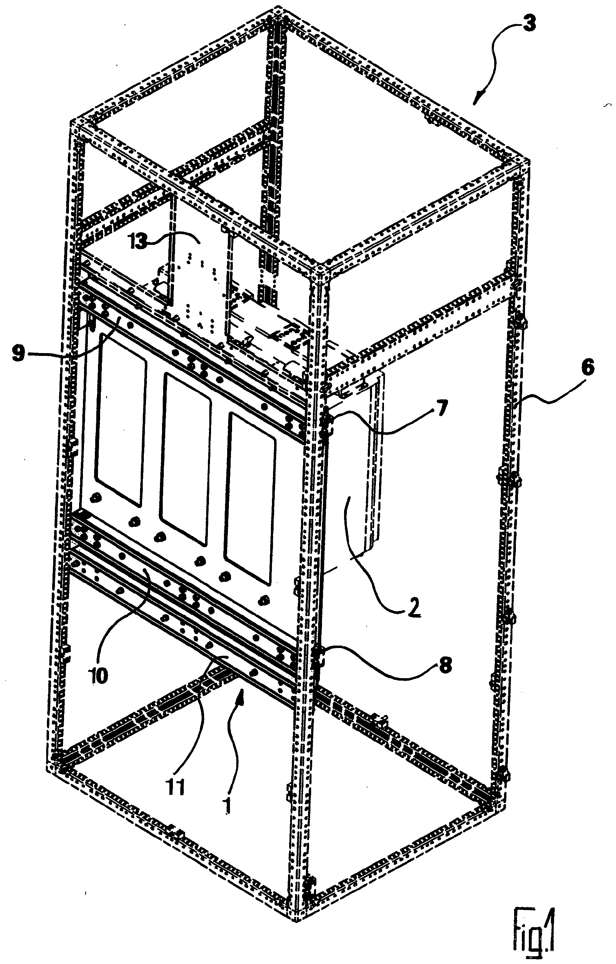

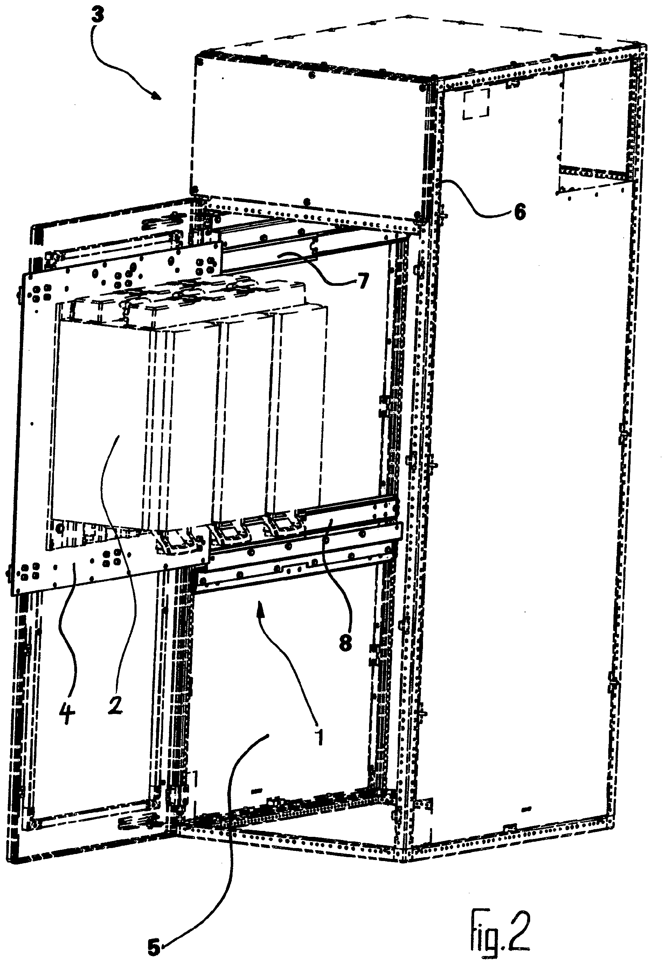

Eine im Folgenden anhand der Figuren 1 bis 5 näher beschriebene Haltevorrichtung 1 zur einschieb- und ausziehbaren Lagerung eines Umformers 2 in einem Schaltschrank 3 ist, wie sich insbesondere aus den perspektivischen Darstellungen in den Figuren 1 und 2 ergibt, im Normalbetrieb des Umformers 2 innerhalb des Schaltschranks 3 angeordnet, wie dies in Figur 1 gezeigt ist, oder, wenn der Umformer 3 gewartet, repariert oder ausgetauscht werden soll, bei geöffnetem Schaltschrank 3 aus dem Schaltschrank 3 ausgezogen angeordnet.

Hierzu weist die Haltevorrichtung in der dargestellten Ausführungsform eine Aufnahmeplatte 4 auf, die flächenparallel zu einer vertikalen Seitenwand 5 des Schaltschranks 3 angeordnet ist.

Der Schaltschrank 3 hat im dargestellten Ausführungsbeispiel eine Rahmenkonstruktion 6, an der die vertikale Seitenwand 5 und die weiteren Seiten- und anderen Wände in geeigneter Weise angebracht sind.

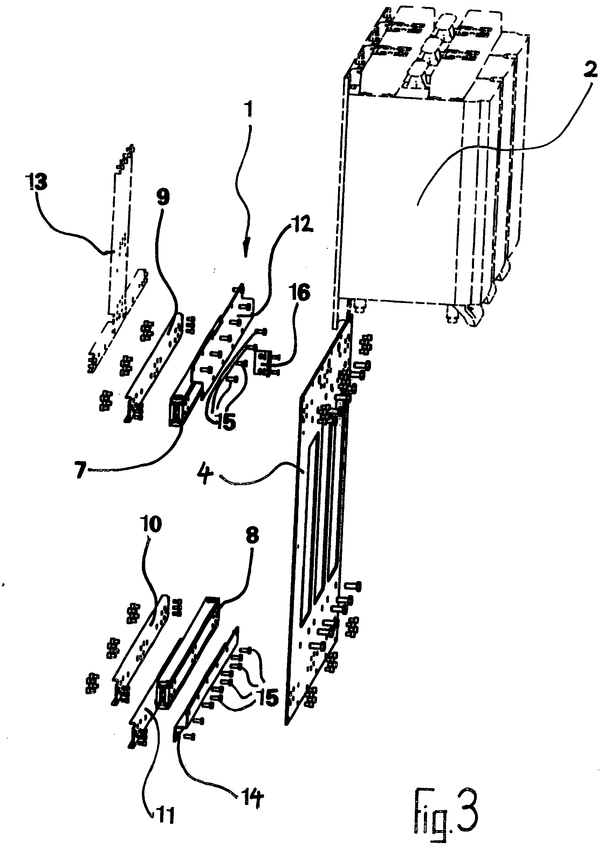

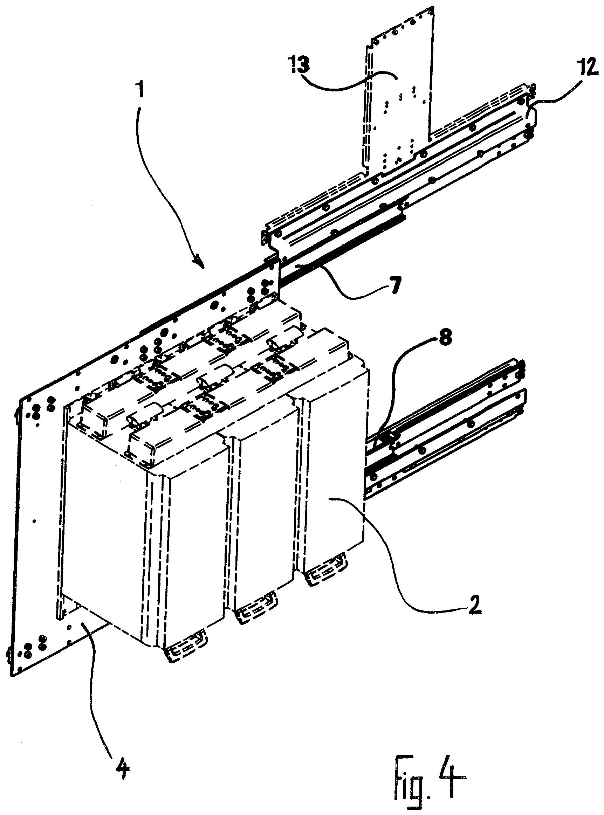

An der der vertikalen Seitenwand 5 des Schaltschranks 3 abgewandten Seite der Aufnahmeplatte 4 ist, wie dies am besten aus einer Zusammenschau der Figuren 3 und 4 hervorgeht, der Umformer 2 mittels einer Vielzahl von Verschraubungen fest angebracht.

Zwischen der dem Umformer 2 abgewandten Seite der Aufnahmeplatte 4 einerseits und der vertikalen Seitenwand 5 des Schaltschranks 3 andererseits sind im dargestellten Ausführungsbeispiel zwei in Vertikalrichtung über- bzw. untereinander angeordnete ausziehbare Schwerlastschienen 7, 8 angeordnet. Die obere Schwerlastschiene 7 ist an einen oberen Endabschnitt der Aufnahmeplatte 4 angeschraubt. Die untere Schwerlastschiene 8 ist an einen unteren Endabschnitt der Aufnahmeplatte 4 angeschraubt. Wie bereits erwähnt, erfolgt die Anbringung der beiden Schwerlastschienen 7, 8 an der Aufnahmeplatte 4 auf der dem Umformer 2 abgewandten Seite derselben. Im dargestellten Ausführungsbeispiel der Haltevorrichtung 1 ist der oberen Schwerlastschiene 7 ein oberes Tragblech 9 zugeordnet, das an der Rahmenkonstruktion 6 des Schaltschranks 3 anmontiert ist. Die obere ausziehbare Schwerlastschiene 7 ist am oberen Tragblech 9 gehaltert.

Der unteren ausziehbaren Schwerlastschiene 8 ist ein erstes unteres Tragblech 10 zugeordnet, das ebenfalls an der Rahmenkonstruktion 6 des Schaltschranks 3 anmontiert ist. Am ersten unteren Tragblech 10 ist die untere ausziehbare Schwerlastschiene 8 der Haltevorrichtung 1 gehaltert.

Im Bereich des unteren Endabschnitts der Aufnahmeplatte 4 der Haltevorrichtung ist ein zweites unteres Tragblech 11 unterhalb des ersten unteren Tragblechs 10 vorgesehen.

Am am oberen Endabschnitt der Aufnahmeplatte 4 vorgesehenen oberen Tragblech 9 ist ein oberes Fixierblech 12 angeordnet, das nicht am oberen Tragblech 9 anmontiert ist sondern an einem Träger 13 befestigt ist, der in die Rahmenkonstruktion 6 des Schaltschranks 3 integriert ist. Die Anbringung des oberen Tragblechs 9 an der Rahmenkonstruktion 6 des Schaltschranks 3 ergibt sich am besten aus Figur 1.

Das erste untere Tragblech 10 und das zweite untere Tragblech 11 bilden am unteren Abschnitt der Aufnahmeplatte 4 der Haltevorrichtung eine Tragblechanordnung 10, 11, an der ein unteres Fixierblech 14 angeordnet ist. Das untere Fixierblech 14 ist einerseits am zweiten unteren Tragblech 11 und andererseits an der Aufnahmeplatte 4 befestigt. Entsprechend dient das zweite untere Tragblech 11 im Wesentlichen bzw. ausschließlich der Befestigung bzw. Fixierung der Aufnahmeplatte 4.

Das obere Fixierblech 12 und das untere Fixierblech 14 sind dazu vorgesehen, die Aufnahmeplatte 4 und mit ihr den Umformer 2 im Normalbetrieb desselben innerhalb des Schaltschranks 3 zu fixieren, wobei hierzu im dargestellten Ausführungsbeispiel jeweils vier Verschraubungen 15 am oberen 12 und unteren Fixierblech 14 vorgesehen sind, mittels denen die Aufnahmeplatte 4 an den beiden Fixierblechen 12, 14 verschraubbar ist.

Wenn der Umformer 2 aus seiner im Schaltschrank 3 fixierten Betriebsstellung bzw. Normalbetriebsstellung in seine aus dem Schaltschrank 3 herausgezogene Ausziehstellung verbracht werden soll, müssen entsprechend die vier am oberen Fixierblech 12 und die vier am unteren Fixierblech 14 vorgesehenen Verschraubungen 15 zunächst gelöst werden. Nach Verbringung des Umformers 2 in seine im Schaltschrank 3 angeordnete Betriebs- bzw. Normalbetriebsstellung ist dann die Aufnahmeplatte 4 wiederum mittels der Verschraubungen 15 am oberen 12 und unteren Fixierblech 14 zu fixieren.

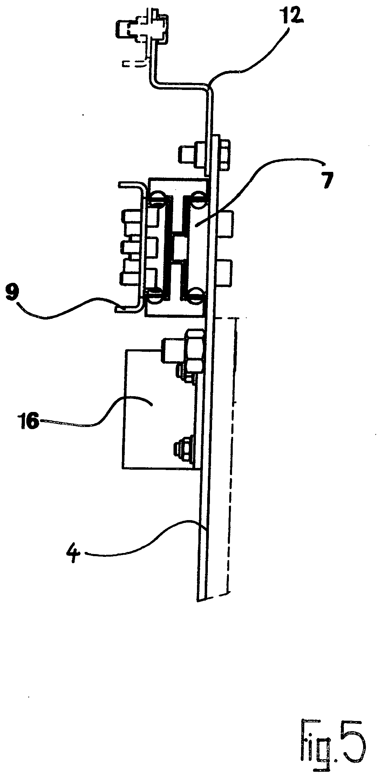

Um mechanische Beschädigungen der Haltevorrichtung 1 bzw. der Rahmenkonstruktion 6 des Schaltschranks 3 zu verhindern und um eine Endlagensicherung der Schwerlastschienen 7, 8 zu schützen, ist die Aufnahmeplatte 4, wie sich am besten aus einer Zusammenschau der Figuren 3 und 5 ergibt, an ihrer der vertikalen Seitenwand 5 des Schaltschranks 3 zugewandten Seite mit einem Winkelstahlglied 16 versehen. Die Anordnung dieses Winkelstahlglieds 16 an der der vertikalen Seitenwand zugewandten Seite der Aufnahmeplatte 4 erfolgt in der Weise, dass das Winkelstahlglied in der vollständig in den Schaltschrank 3 eingeschobenen Stellung der Aufnahmeplatte 4 bzw. des Umformers 2 an einer Innenkante der Rahmenkonstruktion 6 des Schaltschranks 3 anschlägt. Entsprechend schlägt das Winkelstahlglied 16 beim Ausziehen der Aufnahmeplatte 4 bzw. des Umformers 2 aus dem Schaltschrank 3 an eine dieser Innenkante gegenüberliegende Innenkante der Rahmenkonstruktion 6 des Schaltschranks 3 an, so dass das Winkelstahlglied 16 die Auszugbewegung der Aufnahmeplatte 4 blockiert, kurz bevor die Endlagensicherungen der Schwerlastschienen 7, 8 erreicht sind.

## Patentansprüche

1. Schaltschrank (3) mit einer Haltevorrichtung (1), mittels der ein Umformer (2) einschieb- und ausziehbar im Schaltschrank (3) gelagert ist, umfassend eine Aufnahmeplatte (4), die parallel zu einer vertikalen Seitenwand (5) des Schaltschranks (3) angeordnet und an der an ihrer der vertikalen Seitenwand (5) abgewandten Seite der Umformer (2) mittels einer Vielzahl von Verschraubungen fest angebracht ist, zwei ausziehbare Schwerlastschienen (7, 8), von denen die eine (7) mit einem oberen Abschnitt und die andere (8) mit einem unteren Abschnitt der Aufnahmeplatte auf der dem Umformer (2) abgewandten Seite derselben verbunden ist, und zwei Tragbleche (9, 10), an denen jeweils eine der beiden ausziehbaren Schwerlastschienen (7, 8) gehaltert ist und die an einer Rahmenkonstruktion (6) des Schaltschranks (3) montiert sind, wobei der Umformer (2) an seiner Unterseite elektrische Anschlüsse aufweist, deren Zugänglichkeit durch die Haltevorrichtung (1) nicht beeinträchtigt ist.

2. Haltevorrichtung nach Anspruch 1, mit einem weiteren Tragblech (11), das unterhalb des der am unteren Endabschnitt der Aufnahmeplatte (4) angebrachten Schwerlastschiene (8) zugeordneten ersten unteren Tragblechs (10) angeordnet ist, wobei an einem am oberen Endabschnitt der Aufnahmeplatte (4) angeordneten Träger (13) und am am unteren Endabschnitt der Aufnahmeplatte (4) unterhalb des ersten unteren Tragblechs (10) angeordneten weiteren Tragblech (11) jeweils ein Fixierblech (12, 14) angeordnet ist, an denen die den Umformer (2) halternde Aufnahmeplatte (4) im Normalbetrieb des Umformers (2) mittels Verschraubungen (15) fixierbar ist.

3. Haltevorrichtung nach Anspruch 1 oder 2, mit einem Winkelstahlglied (16), das so an der Aufnahmeplatte (4) befestigt ist, dass es in der vollständig in den Schaltschrank (3) eingeschobenen und in der vollständig aus dem Schaltschrank (3) ausgezogenen Grenzstellung der Aufnahmeplatte (4) bzw. des Umformers (2) an Innenkanten der Rahmenkonstruktion (6) des Schaltschranks (3) anschlägt, wobei es die Bewegung der Aufnahmeplatte (4) bzw. des Umformers (2) in Auszugrichtung blockiert, kurz bevor eine Endlagensicherung der Schwerlastschienen (7, 8) erreicht ist.

4. Haltevorrichtung nach Anspruch 2 oder 3, bei der der das am am oberen Endabschnitt der Aufnahmeplatte (4) angeordneten Tragblech (9) angeordnete Fixierblech (12) halternde Träger (13) in die Rahmenkonstruktion (6) des Schaltschranks (3) integriert ist.

5. Haltevorrichtung nach einem der Ansprüche 2 bis 4, bei der das an der aus den beiden am unteren Endabschnitt der Aufnahmeplatte (4) angeordneten Tragblechen (10, 11) gebildeten Tragblechanordnung (10, 11) angeordnete Fixierblech (14) am unterhalb des ersten unteren Tragblechs (10) angeordneten weiteren Tragblech (11) dieser Tragblechanordnung (10, 11) befestigt ist.

6. Haltevorrichtung nach einem der Ansprüche 1 bis 5, deren Aufnahmeplatte (4) auf ihrer dem Umformer (2) abgewandten Seite mittels daran angebrachter, vorzugsweise angeschweißter Versteifungsstreben verstärkt ist.

7. Haltevorrichtung nach einem der Ansprüche 3 bis 6, mit einem weiteren Winkelstahlglied, wobei das Winkelstahlglied (16) und das weitere Winkelstahlglied verstellbar an einem Sockelblech anschraubbar sind, das an der dem Umformer (2) abgewandten Seite der Aufnahmeplatte (4) angebracht, vorzugsweise angeschweißt ist.

## Claims

1. Control cabinet (3) having a holding device (1) by means of which a converter (2) is mounted so as to be insertable in and removable from the control cabinet (3), comprising a mounting plate (4) which is arranged parallel to a vertical side wall (5) of the control cabinet (3) and to which the converter (2) is firmly attached on its side facing away from the vertical side wall (5) by means of a plurality of screw connections, two extendable heavy-duty rails (7, 8), one of which (7) is connected to an upper section and the other (8) to a lower section of the mounting plate on the side of same facing away from the converter (2), and two support plates (9, 10) on which respectively one of the two extendable heavy-duty rails (7, 8) is supported and which are mounted on a frame construction (6) of the control cabinet (3), wherein the converter (2) has electrical connections on its lower side, the accessibility of which is not impaired by the holding device (1).

2. Holding device according to Claim 1, having a further support plate (11) which is arranged below the first lower support plate (10) assigned to the heavy-duty rail (8) attached to the lower end section of the mounting plate (4), wherein a fixing plate (12, 14) is respectively arranged on one support (13) arranged at the upper end section of the mounting plate (4) and on the other support plate (11) arranged at the lower end section of the mounting plate (4) below the first lower support plate (10), to which fixing plate (12, 14) the mounting plate (4) supporting the converter (2) can be fixed by means of screw connections (15) when the converter (2) is in normal operation.

3. Holding device according to Claim 1 or 2, having an angle steel link (16) which is attached to the mounting plate (4) such that it abuts against inner edges of the frame construction (6) of the control cabinet (3) in the limit position of the mounting plate (4) or converter (2) fully inserted into the control cabinet (3) and fully pulled out of the control cabinet (3), wherein it blocks the movement of the mounting plate (4) or converter (2) in the pull-out direction shortly before a limit lock of the heavy-duty rails (7, 8) is reached.

4. Holding device according to Claim 2 or 3, in which the support (13) supporting the fixing plate (12) arranged on the support plate (9) arranged at the upper end section of the mounting plate (4) is integrated into the frame construction (6) of the control cabinet (3).

5. Holding device according to one of Claims 2 to 4, in which the fixing plate (14) arranged on the support plate arrangement (10, 11) formed from the two support plates (10, 11) arranged at the lower end section of the mounting plate (4) is attached to the other support plate (11) of this support plate arrangement (10, 11) arranged below the first lower support plate (10).

6. Holding device according to one of Claims 1 to 5, the mounting plate (4) of which is reinforced on its side facing away from the converter (2) by means of reinforcing struts attached thereto, preferably welded thereto.

7. Holding device according to one of Claims 3 to 6, having a further angle steel link, wherein the angle steel link (16) and the further angle steel link can be adjustably screwed onto a base plate, which is attached to the side of the mounting plate (4) facing away from the converter (2), preferably welded thereto.

## Revendications

1. Armoire de distribution (3) dotée d'un dispositif de retenue (1), au moyen duquel un convertisseur (2) est logé de manière insérable et extractible dans l'armoire de distribution (3), comprenant une plaque réceptrice (4), qui est placée à la parallèle d'une paroi latérale (5) verticale de l'armoire de distribution (3) et sur laquelle, sur son côté opposé à la paroi latérale (5) verticale, le convertisseur (2) est monté fixement à l'aide d'une pluralité de boulonnages, deux glissières pour charges lourdes (7, 8) extractibles, dont l'une (7) est assemblée avec une partie supérieure et l'autre (8) avec une partie inférieure de la plaque réceptrice, sur le côté opposé au convertisseur (2) de celle-ci, et deux tôles porteuses (9, 10), sur lesquelles est maintenue respectivement l'une des deux glissières pour charges lourdes (7, 8) extractibles et qui sont montées sur une structure du cadre (6) de l'armoire de distribution (3), le convertisseur (2) comportant sur sa face inférieure des raccordements électriques, dont l'accessibilité n'est pas entravée par le dispositif de retenue (1).

2. Dispositif de retenue selon la revendication 1, pourvu d'une tôle porteuse (11) supplémentaire, qui est placée en-dessous de la première tôle porteuse (10) inférieure, associée à la glissière pour charges lourdes (8) montée sur la partie d'extrémité inférieure de la plaque réceptrice (4), sur un support (13) placé sur la partie d'extrémité supérieure de la plaque réceptrice (4) et sur la tôle porteuse (11) supplémentaire placée sur la partie d'extrémité inférieure de la plaque réceptrice (4), en-dessous de la première tôle porteuse (10) inférieure étant placée respectivement une tôle de fixation (12, 14), sur lesquelles en fonctionnement normal du convertisseur (2), la plaque réceptrice (4) maintenant le convertisseur (2) peut être fixée au moyen de boulonnages (15).

3. Dispositif de retenue selon la revendication 1 ou 2, pourvu d'un élément en cornière (16), qui est fixé sur la plaque réceptrice (4), de sorte que dans la position limite totalement insérée dans l'armoire de distribution (3) et totalement extraite de l'armoire de distribution (3) de la plaque réceptrice (4) ou du convertisseur (2), il bute sur des arêtes intérieures de la structure du cadre (6) de l'armoire de distribution (3), en bloquant le déplacement de la plaque réceptrice (4) ou du convertisseur (2) dans la direction d'extraction, peu avant l'atteinte d'un blocage de la position extrême des glissières pour charges lourdes (7, 8).

4. Dispositif de retenue selon la revendication 2 ou 3, sur lequel le support (13) maintenant la tôle de fixation (12) placée sur la tôle porteuse (9) placée sur la partie d'extrémité supérieure de la plaque réceptrice (4) est intégré dans la structure du cadre (6) de l'armoire de distribution (3).

5. Dispositif de retenue selon l'une quelconque des revendications 2 à 4, sur lequel la tôle de fixation (14) placée sur l'ensemble de tôles porteuses (10, 11) formé par les deux tôles porteuses (10, 11) placées sur la partie d'extrémité inférieure de la plaque réceptrice (4) est fixé sur la tôle porteuse (11) supplémentaire dudit ensemble de tôles porteuses (10, 11) qui est placée en dessous de la première tôle porteuse (10) inférieure.

6. Dispositif de retenue selon l'une quelconque des revendications 1 à 5, dont la plaque réceptrice (4) est renforcée sur sa face opposée au convertisseur (2) au moyen de traverses de renfort montées, de préférence soudées sur celle-ci.

7. Dispositif de retenue selon l'une quelconque des revendications 3 à 6, pourvu d'un élément en cornière supplémentaire, l'élément en cornière (16) et l'élément en cornière supplémentaire étant aptes à être vissés de manière ajustable sur une tôle formant socle qui est montée, de préférence soudée sur la face opposée au convertisseur (2) de la plaque réceptrice (4) .
